# EUROPEAN PATENT APPLICATION

(11) **EP 4 733 827 A1**
(43) Date of publication of application: **29.04.2026**
(21) Application number: 24872691.1
(22) Date of filing: 23.07.2024
(51) Int. Cl.: G02B 27/01, G06F 1/20, H05K 5/02

(54) **WEARABLE DEVICE INCLUDING HEAT DISSIPATION STRUCTURE**

(30) Priority: 27.09.2023 KR 20230131261; 21.11.2023 KR 20230162811
(71) Applicant: Samsung Electronics Co., Ltd., Suwon-si, Gyeonggi-do 16677 (KR)
(72) Inventor: LEE, Haejin, Suwon-si Gyeonggi-do 16677 (KR); AHN, Joseph, Suwon-si Gyeonggi-do 16677 (KR)
(74) Representative: Gulde & Partner
(86) International application number: PCT/KR2024/010622
(87) International publication number: WO 2025/070981

(57) **Abstract**

A wearable device according to an embodiment of the present invention may include: a frame including at least one inlet; a printed circuit board disposed in the frame; an electronic component disposed on the printed circuit board; and a shield can disposed on the printed circuit board and at least partially surrounding the electronic component. The wearable device may include a housing coupled to the shield can. The wearable device may include an actuator facing the housing. The actuator may be configured to move air, received through the at least one inlet, toward the housing.

## Description

### [Technical Field]

The disclosure relates to a wearable device including a heat dissipation structure.

### [Background Art]

A wearable device may be used in a state of being worn on a part of a body of a user. The wearable device may be provided in various type of a product. For example, the wearable device may include a glasses-type device to provide an augmented reality (AR) or a virtual reality (VR) to the user. As the wearable device performs various functions to meet a demand of the user, heat may be generated from an electronic component in the wearable device. The wearable device may require a structure to dissipate heat generated from the electronic component in the wearable device in order to reduce the degradation of the function of the wearable device.

The above-described information may be provided as a related art for the purpose of helping to understand the present disclosure. No claim or determination is raised as to whether any of the above-described information may be applied as a prior art associated with the present disclosure.

### [Disclosure]

### [Technical Solution]

According to an example embodiment, the wearable device may include: a frame including at least one inlet, a printed circuit board disposed in the frame, an electronic component disposed on the printed circuit board, a shield can, coupled to the printed circuit board, at least partially surrounding the electronic component, a housing, coupled with the shield can, including a cover plate including a first portion disposed on the electronic component and a second portion surrounding the first portion, an actuator disposed toward the second portion, wherein actuator may be configured to move air received through the at least one inlet toward the second portion.

According to an example embodiment, the wearable device may include: a frame including at least one inlet, a printed circuit board disposed in the frame, an electronic component disposed on the printed circuit board, a housing including a cover plate including a first portion disposed on the electronic component and a second portion surrounding the first portion, an actuator including a first surface, disposed toward the second portion, including a first openings, a second surface, opposite to the first surface, including a second openings, and a protrusion, extending from the second surface to the second portion, attached to the second portion, wherein actuator may be configured to move air received through the at least one inlet from the first surface toward the second portion.

### [Description of the Drawings]

FIG. 1 is a block diagram of an example of an electronic device in a network environment according to various embodiments;
FIG. 2 illustrates an example of a perspective view of an electronic device according to various embodiments;
FIG. 3 illustrates an example of one or more hardware components disposed in an electronic device, according to various embodiments;
FIG. 4A illustrates a part of a frame of an example of an electronic device according to various embodiments;
FIG. 4B is a partial cross-sectional view of an example of an electronic device taken along line A-A' of FIG. 4A according to various embodiments;
FIGS. 4C and 4D are a partial exploded perspective views of an example of an electronic device according to various embodiments;
FIG. 5A illustrates a part of an example of an electronic device according to various embodiments;
FIG. 5B is a partial cross-sectional view of an example of an electronic device taken along line B-B' of FIG. 5A according to various embodiments;
FIG. 5C illustrates a part of an example of an electronic device according to various embodiments;
FIG. 6A and FIG. 6B illustrate a portion of an example of an electronic device according to various embodiments; and
FIG. 7 illustrates an example of an electronic device according to various embodiments.

### [Mode for Invention]

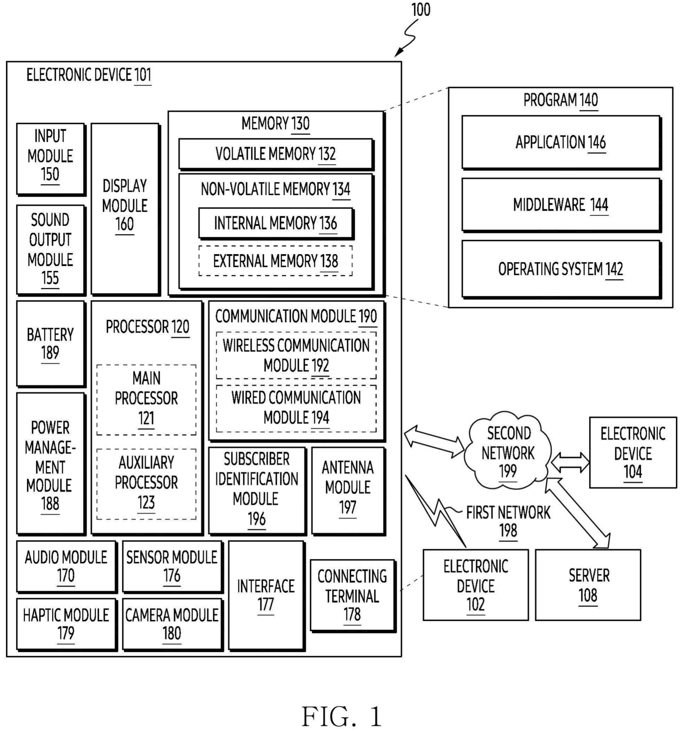

FIG. 1 is a block diagram of an example electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may include various processing circuitry and/or multiple processors. For example, as used herein, including the claims, the term "processor" may include at least one processor, including various processing circuitruy, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

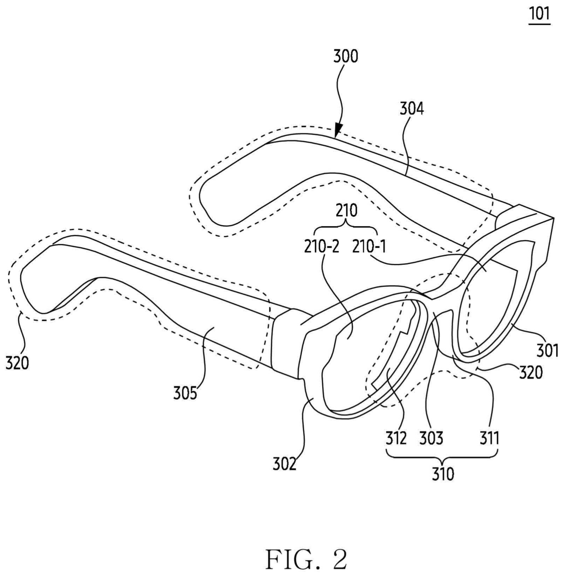

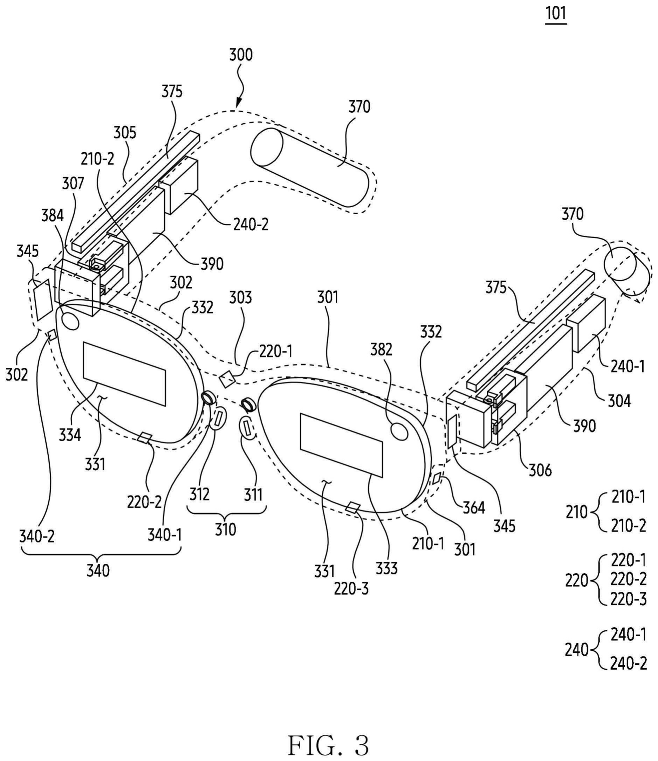

FIG. 2 illustrates an example of a perspective view of an electronic device according to various embodiments. FIG. 3 illustrates an example of one or more hardware components disposed in an electronic device, according to various embodiments.

Referring to FIGS. 2 and 3, an electronic device 101 may be referred to as a wearable device worn on a part of a body of a user.

According to an embodiment, the electronic device 101 may be worn on the part of the body of the user. The electronic device 101 may provide an augmented reality (AR), a virtual reality (VR), or a mixed reality (MR) that combines the augmented reality and the virtual reality to the user wearing the electronic device 101. For example, the electronic device 101 may display a virtual reality image provided by at least one optical device 382 and 384 of FIG. 3 on at least one display 210 in response to a designated gesture of the user obtained through a gesture recognition camera 340-2 of FIG. 3.

According to an embodiment, at least one display 210 may provide visual information to the user. For example, at least one display 210 may include a transparent or translucent lens. At least one display 210 may include a first display 210-1 and/or a second display 210-2 spaced apart from the first display 210-1. For example, the first display 210-1 and the second display 210-2 may be disposed at locations corresponding to left and right eyes of the user, respectively.

Referring to FIG. 3, at least one display 210 may provide visual information transmitted from external light to the user through a lens included in at least one display 210 and other visual information distinguished from the visual information. For example, the lens may be formed based on at least one of a Fresnel lens, a pancake lens, or a multi-channel lens. For example, at least one display 210 may include a front surface 331 and a rear surface 332 opposite to the front surface 331. A display area may be formed on the rear surface 332 of at least one display 210. When the user wears the electronic device 101, the external light may be transmitted to the user by being incident on the front surface 331 and transmitted through the rear surface 332. For another example, at least one display 210 may display the augmented reality image in which the virtual reality image provided by at least one optical device 382 and 384 is combined with a reality screen transmitted through external light on the display area formed on the rear surface 332.

In an embodiment, at least one display 210 may include at least one waveguide 333 and 334 that diffracts light transmitted from at least one optical device 382 and 384 and transmits it to the user. At least one waveguide 333 and 334 may be formed based on at least one of glass, plastic, or polymer. A nano pattern may be formed on at least the part of an outside or an inside of at least one waveguide 333 and 334. The nano pattern may be formed based on a polygonal and/or a curved grating structure. Light incident to an end of at least one waveguide 333 and 334 may propagate to another end of at least one waveguide 333 and 334 by the nano pattern. At least one waveguide 333 and 334 may include at least one of at least one diffractive element (e.g., a diffractive optical element (DOE), a holographic optical element (HOE)) and a reflective element (e.g., a reflective mirror). For example, at least one waveguide 333 and 334 may be disposed in the electronic device 101 to guide a screen displayed by at least one display 210 to an eye of the user. For example, the screen may be transmitted to the eye of the user based on total internal reflection (TIR) generated in at least one waveguide 333 and 334.

The electronic device 101 may analyze an object included in the reality image collected through a shooting camera (not illustrated) (e.g., a camera 340 in FIG. 3), combine a virtual object corresponding to the object to be provided with the augmented reality among the analyzed object, and display it on at least one display 210. The virtual object may include at least one of text and image on various information associated with the object included in the reality image. The electronic device 101 may analyze the object based on a multi-camera such as a stereo camera. For the object analysis, the electronic device 101 may execute a time-of-flight (ToF) and/or a simultaneous localization and mapping (SLAM) supported by the multi-camera. A user wearing the electronic device 101 may view the image displayed on at least one display 210.

According to an embodiment, a frame 300 may be made of a physical structure that allows the electronic device 101 to be worn on the body of the user. According to an embodiment, the frame 300 may be configured so that the first display 210-1 and the second display 210-2 may be located at a location corresponding to the left eye and the right eye of the user, when the user wears the electronic device 101. The frame 300 may support at least one display 210. For example, the frame 300 may support the first display 210-1 and the second display 210-2 to be located at the location corresponding to the left eye and the right eye of the user.

Referring to FIG. 2, in case that the user wears the electronic device 101, the frame 300 may include an area 320 that at least partially contacts the part of the body of the user. For example, the area 320 in contact with the part of the body of the user of the frame 300 may include the area in contact with the part of a nose of the user, the part of an ear of the user, and the part of a side of a face of the user, in which the electronic device 101 contacts. According to an embodiment, the frame 300 may include a nose pad 310 in contact with the part of the body of the user. When the electronic device 101 is worn by the user, the nose pad 310 may be in contact with the part of the nose of the user. The frame 300 may include a first temple 304 and a second temple 305 in contact with another part of the body of the user distinguished from the part of the body of the user.

For example, the frame 300 may include a first rim 301 surrounding at least part of the first display 210-1, a second rim 302 surrounding at least the part of the second display 210-2, a bridge 303 disposed between the first rim 301 and the second rim 302, a first pad 311 disposed along the part of a periphery of the first rim 301 from an end of the bridge 303, a second pad 312 disposed along the part of the periphery of the second rim 302 from another end of the bridge 303, a first temple 304 extended from the first rim 301 and fixed to the part of the ear of a wearer, and a second temple 305 extended from the second rim 302 and fixed to the part of the ear opposite to the ear. The first pad 311 and the second pad 312 may contact the part of the nose of the user, and the first temple 304 and the second temple 305 may contact the part of the face and the part of the ear of the user. The temple 304 and 305 may be rotatably connected to the rim through hinge units 306 and 307 of FIG. 3. The first temple 304 may be rotatably connected to the first rim 301 through the first hinge unit 306 disposed between the first rim 301 and the first temple 304. The second temple 305 may be rotatably connected to the second rim 302 through the second hinge unit 307 disposed between the second rim 302 and the second temple 305. According to an embodiment, the electronic device 101 may identify an external object (e.g., a fingertip of the user) touching the frame 300, and/or a gesture performed by the external object, using a touch sensor, a grip sensor, and/or a proximity sensor formed on at least the part of a surface of the frame 300.

According to an embodiment, the electronic device 101 may include various components, including hardware that performs various functions. For example, the hardware may include a battery module (e.g., including a battery) 370, an antenna module (e.g., including an antenna) 375, at least one optical device 382 and 384, a speaker module (e.g., including a speaker) 240, a microphone array 220, a light emitting module (e.g., including light emitting elements) 345 and/or a PCB 390. Various hardware may be disposed in the frame 300.

According to an embodiment, the microphone array 220 of the electronic device 101 may be disposed on at least the part of the frame 300 and obtain a sound signal. For example, the microphone array 220 may include a first microphone 220-1, a second microphone 220-2, or a third microphone 220-3. The first microphone 220-1 disposed on the nose pad 310, the second microphone 220-2 disposed on the second rim 302, and the third microphone 220-3 disposed on the first rim 301 are illustrated in FIG. 3, but the number and disposition of the microphone are not limited to an embodiment of FIG. 3. In case that the number of microphone included in the electronic device 101 is two or more, the electronic device 101 may identify a direction of the sound signal using a plurality of microphones disposed on different parts of the frame 300.

According to an embodiment, at least one optical device 382 and 384 may project the virtual object on at least one display 210 to provide various image information to the user. For example, at least one optical device 382 and 384 may be a projector. At least one optical device 382 and 384 may be disposed adjacent to at least one display 210 or included in at least one display 210 as the part of at least one display 210. According to an embodiment, the electronic device 101 may include a first optical device 382 corresponding to the first display 210-1 and a second optical device 384 corresponding to the second display 210-2. For example, at least one optical device 382 and 384 may include the first optical device 382 disposed at the periphery of the first display 210-1 and the second optical device 384 disposed at the periphery of the second display 210-2. The first optical device 382 may transmit light to a first waveguide 333 disposed on the first display 210-1, and the second optical device 384 may transmit light to a second waveguide 334 disposed on a second display 210-2.

In an embodiment, the camera 340 may include the shooting camera, an eye tracking camera (ET CAM) 340-1, and/or the gesture recognition camera 340-2. The shooting camera, the eye tracking camera 340-1, and the gesture recognition camera 340-2 and 340-3 may be disposed at different locations on the frame 300 and may perform different functions. The eye tracking camera 340-1 may output data representing a gaze of the user wearing the electronic device 101. For example, the electronic device 101 may detect the gaze from an image including a pupil of the user obtained through the eye tracking camera 340-1. An example in which the eye tracking camera 340-1 is disposed toward the right eye of the user is illustrated in FIG. 3, but an embodiment is not limited thereto, and the eye tracking camera 340-1 may be disposed alone toward the left eye of the user or toward both eyes.

In an embodiment, the shooting camera may shoot a real image or a background to be matched with a virtual image to implement the augmented reality or a mixed reality content. The shooting camera may shoot the image of a specific object existing at the location where the user is looking and provide the image to at least one display 210. At least one display 210 may display one image in which information on the real image or the background including the image of the specific object obtained using the shooting camera and the virtual image provided through at least one optical device 382 and 384 are overlapped. In an embodiment, the shooting camera may be disposed on the bridge 303 disposed between the first rim 301 and the second rim 302.

The eye tracking camera 340-1 may realize more realistic augmented reality by matching the gaze of the user with visual information provided to at least one display 210 by tracking the gaze of the user wearing the electronic device 101. For example, when the user looks at the front, the electronic device 101 may naturally display environmental information associated with the front of the user in a place where the user is located on at least one display 210. The eye tracking camera 340-1 may be configured to capture the image of the pupil of the user to determine the gaze of the user. For example, the eye tracking camera 340-1 may receive gaze detection light reflected from the pupil of the user and track the gaze of the user based on the location and a motion of received gaze detection light. In an embodiment, the eye tracking camera 340-1 may be disposed at the location corresponding to the left eye and the right eye of the user. For example, the eye tracking camera 340-1 may be disposed to face the direction in which the user wearing the electronic device 101 is located in the first rim 301 and/or the second rim 302. For example, a motion recognition camera 364 may be disposed in the second rim 302. For example, the motion recognition camera 364 may perform substantially the same operation as the gesture recognition camera 340-2 included in the first rim 301.

The gesture recognition camera 340-2 may provide a specific event to a screen provided to at least one display 210 by recognizing the motion of all or the part of the body of the user, such as a torso, a hand, or a face of the user. The gesture recognition camera 340-2 may obtain a signal corresponding to the operation by recognizing gesture of the user, and provide the display corresponding to the signal to at least one display 210. A processor may identify the signal corresponding to the operation and perform a designated function based on the identification. In an embodiment, the gesture recognition camera 340-2 may be disposed on the first rim 301 and/or the second rim 302.

The camera 340 included in the electronic device 101 is not limited to the eye tracking camera 340-1 and the gesture recognition camera 340-2 described above. For example, using the camera 340 disposed toward FoV of user, the electronic device 101 may identify the external object included in the field of view (FoV). Identification of the external object by the electronic device 101 may be performed based on a sensor, such as a depth sensor and/or the time of flight (ToF) sensor, for identifying a distance between the electronic device 101 and the external object. The camera 340 disposed toward the FoV may support an autofocus function and/or an optical image stabilization (OIS) function. For example, the electronic device 101 may include the camera 340 (e.g., a face tracking (FT) camera) disposed toward the face in order to obtain the image including the face of the user wearing the electronic device 101.

Although not illustrated, the electronic device 101, according to an embodiment, may further include a light source (e.g., LED) that discharges light toward a subject (e.g., the eye, the face of the user and/or the external object in FoV) shot using the camera 340. The light source may include an LED having an infrared wavelength. The light source may be disposed on at least one of the frame 300 and the hinge units 306 and 307.

According to an embodiment, the battery module 370 may supply power to electronic components of the electronic device 101. In an embodiment, the battery module 370 may be disposed in the first temple 304 and/or the second temple 305. For example, the battery module 370 may be the plurality of battery modules 370. The plurality of battery modules 370 may be disposed on each of the first temple 304 and the second temple 305, respectively. In an embodiment, the battery module 370 may be disposed at the end of the first temple 304 and/or the second temple 305.

The antenna module 375 may transmit the signal or power to the outside of the electronic device 101 or may receive the signal or power from the outside. The antenna module 375 may be electrically and/or operatively connected to a communication module (e.g., a communication module 190 of FIG. 1) on the PCB 390. In an embodiment, the antenna module 375 may be disposed in the first temple 304 and/or the second temple 305. For example, the antenna module 375 may be disposed close to one surface of the first temple 304, and/or the second temple 305.

The speaker module 240 may output an audio signal to the outside of the electronic device 101. An acoustic output module may be referred to as the speaker module. In an embodiment, the speaker module 240 may be disposed in the first temple 304 and/or the second temple 305 to be disposed adjacent to the ear of the user wearing the electronic device 101. For example, the speaker module 240 may include a first speaker module 240-1 disposed adjacent to the left ear of the user by being disposed in the first temple 304, and a second speaker module 240-2 disposed adjacent to the right ear of the user by being disposed in the second temple 305.

The light emitting module 345 may include at least one light emitting element. In order to visually provide information on a specific state of the electronic device 101 to the user, the light emitting module 345 may discharge light of a color corresponding to the specific state or light in the operation corresponding to the specific state. For example, when requiring charging, the electronic device 101 may discharge red light at regular intervals. In an embodiment, the light emitting module 345 may be disposed on the first rim 301 and/or the second rim 302.

Referring to FIG. 3, the electronic device 101 according to an embodiment may include the printed circuit board (PCB) 390. The PCB 390 may be included in at least one of a first temple 304 and a second temple 305. The PCB 390 may include an interposer disposed between at least two sub-PCBs. On the PCB 390, one or more hardware included in the electronic device 101 may be disposed. The electronic device 101 may include a flexible PCB (FPCB) for interconnecting the hardware.

According to an embodiment, the electronic device 101 may include at least one of a gyro sensor, a gravity sensor, and/or an acceleration sensor for detecting a posture of the electronic device 101 and/or a posture of the part (e.g., a head) of the body of the user wearing the electronic device 101. Each of the gravity sensor and the acceleration sensor may measure gravity acceleration and/or acceleration based on designated three-dimensional axes (e.g., x-axis, y-axis, and z-axis) perpendicular to each other. The gyro sensor may measure an angular velocity of each of the designated 3D axes (e.g., x-axis, y-axis, and z-axis). At least one of the gravity sensor, the acceleration sensor, and the gyro sensor may be referred to as an inertial measurement unit (IMU). According to an embodiment, the electronic device 101 may identify the motion and/or the gesture of the user performed to execute or stop a specific function of the electronic device 101 based on the IMU.

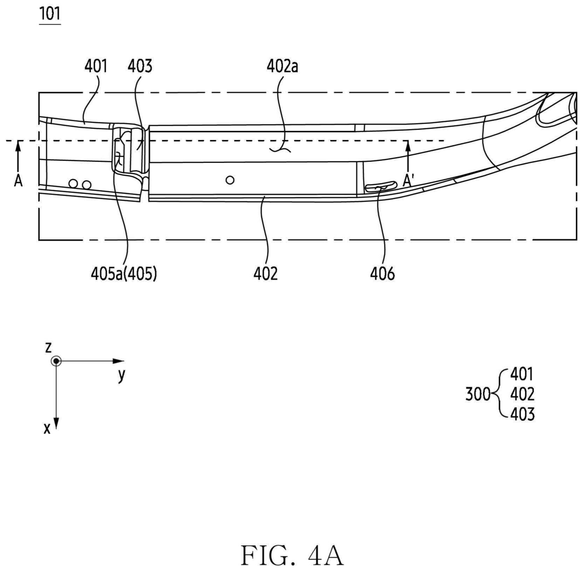

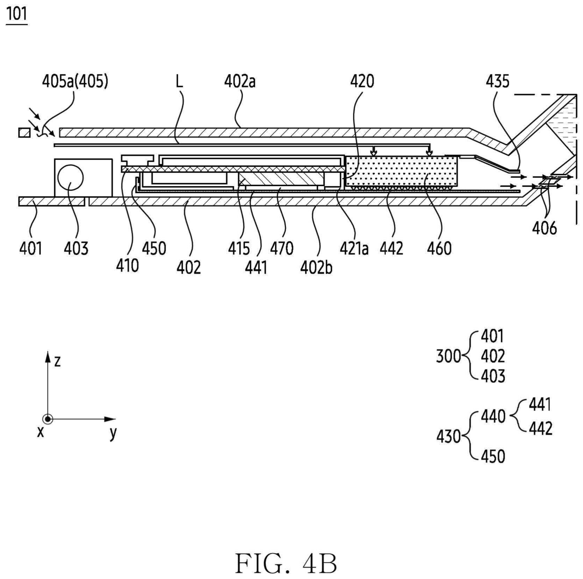

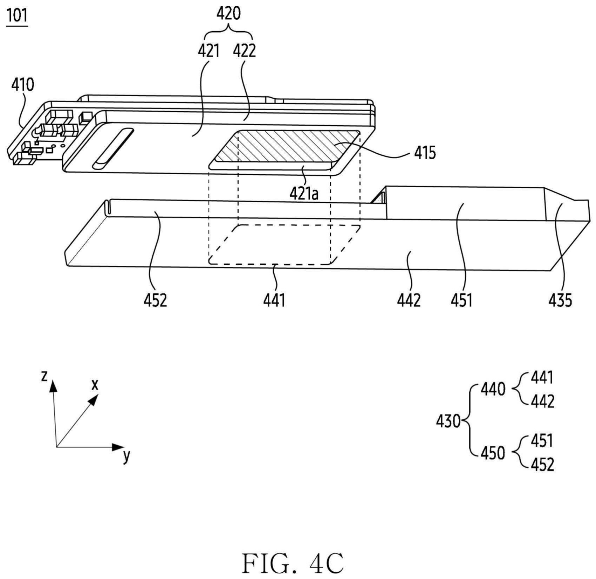

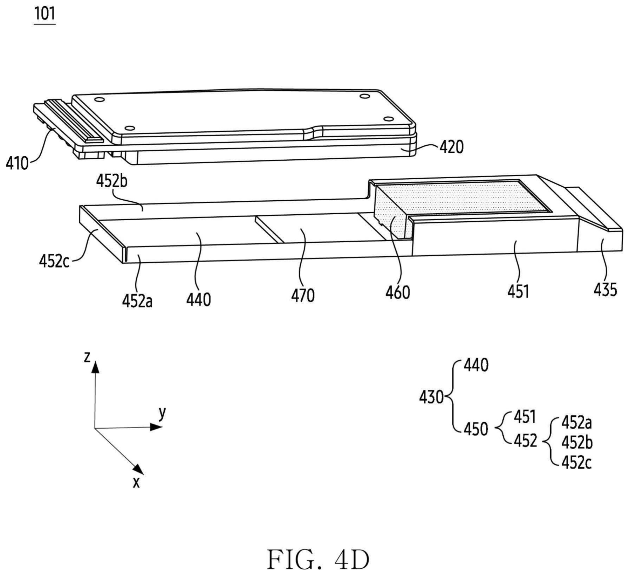

FIG. 4A illustrates a part of a frame of an example of an electronic device according to various embodiments. FIG. 4B is a partial cross-sectional view of an example of an electronic device taken along line A-A' of FIG. 4A according to various embodiments. FIGS. 4C and 4D are a partial exploded perspective views of an example of an electronic device.

Referring to FIGS. 4A, 4B, 4C, and 4D, the electronic device 101 may include a frame 300, a printed circuit board 410, an electronic component 415, a shield can 420, a housing 430, and an actuator 460.

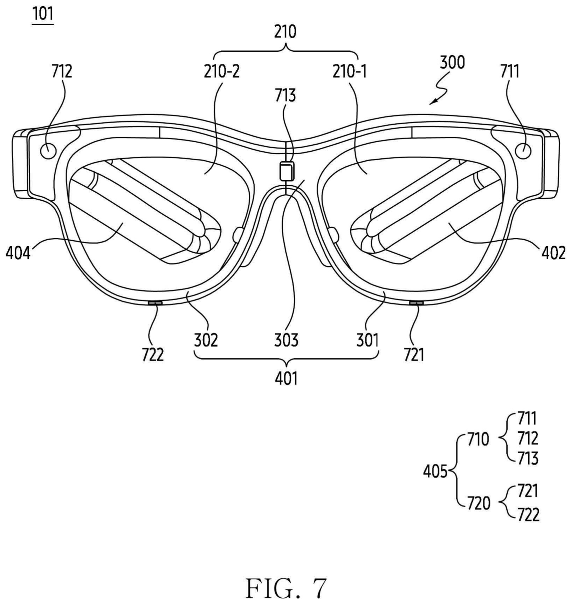

According to an embodiment, the frame 300 may include at least one inlet 405. For example, at least one inlet 405 may penetrate the frame 300. The at least one inlet 405 may be a passage for air being flowed (or received) into the inner space of the frame 300 from an outside of the frame 300. For example, the frame 300 may include a plurality of frames (e.g., a first frame 401 and a second frame 402) coupled to each other. At least one inlet 405 may be located at a joint of the frame 300 to which the plurality of frames is connected. However, the disclosure is not limited to thereto. The frame 300 may include the plurality of inlets for air being flowed into the inner space of the frame 300 from the outside of the frame 300 to cool electronic components inside the frame 300. The formation of the plurality of inlets in the frame 300 will be described in greater detail below with reference to FIG. 7.

According to an embodiment, the printed circuit board 410 may be disposed in the frame 300. For example, the printed circuit board 410 may be covered by the frame 300. For example, the printed circuit board 410 may be fastened inside the frame 300. The printed circuit board 410 may be supported by a structure (e.g., a bracket) inside the frame 300, but is not limited thereto. For example, the printed circuit board 410 may be surrounded by the frame 300. The electronic components of the electronic device 101 may be mounted on the printed circuit board 410.

According to an embodiment, the electronic component 415 may be disposed on the printed circuit board 410. For example, the electronic component 415 may be coupled to the printed circuit board 410. The electronic component 415 may receive power from a battery (e.g., a battery module 370 of FIG. 3) through the printed circuit board 410, by being electrically connected to the printed circuit board 410. For example, the electronic component 415 may be disposed between the printed circuit board 410 and the frame 300. For example, the electronic component 415 may be a processor (e.g., a processor 120 of FIG. 1) of the electronic device 101. As the electronic device 101 operates, the electronic component 415 may dissipate heat by performing an operation. For example, at least the part of heat generated from the electronic component 415 may be transferred to the frame 300. The electronic device 101 may require a structure to reduce heat transferred from the electronic component 415 to the frame 300.

According to an embodiment, the electronic device 101 may include at least one display (e.g., at least one display 210 of FIG. 2). The frame 300 may include a first frame 401 supporting the at least one display 210, a second frame 402 supported by the part (e.g., an ear) of a body of a user while the electronic device 101 is worn on the user, and a hinge structure 403 rotatably connecting the second frame 402 to the first frame 401. The printed circuit board 410 may be disposed in the second frame 402.

For example, the first frame 401 may be coupled with at least one display 210 configured to provide visual information to the user. For example, the first frame 401 may be the part including of a first rim (e.g., a first rim 301 of FIG. 2), a second rim (e.g., a second rim 302 of FIG. 2), and a bridge (e.g., a bridge 303 of FIG. 2) connecting the first rim 301 and the second rim 302 of the frame 300.

For example, the second frame 402 may be coupled with the first frame 401. The second frame 402 may support the first frame 401 by being coupled with the first frame 401. For example, the second frame 402 may be one of the temple (e.g., a first temple 304 and a second temple 305 in FIG. 2) of the electronic device 101, but is not limited thereto.

For example, the hinge structure 403 may rotatably couple the first frame 401 and the second frame 402. The hinge structure 403 may be at least partially disposed between the first frame 401 and the second frame 402. The hinge structure 403 may be one of hinge units 306 and 307 of FIG. 3, but is not limited thereto.

For example, the second frame 402 may be mounted on the part (e.g., an ear) of the body of the user while the electronic device 101 is worn on the user. At least the part of the second frame 402 may be in contact with the part of the body of the user. One surface 402a of the second frame 402 may face the part of the body of the user while the electronic device 101 is worn on the user. For example, the first frame 401 may be mounted on another part (e.g., a nose) of the body of the user while the second frame 402 is mounted on the part of the body of the user. The frame 300 may be configured so that the electronic device 101 may be easily worn by the user, by including the first frame 401 and the second frame 402.

For example, the printed circuit board 410 may be covered by the second frame 402. For example, the printed circuit board 410 may be disposed between one surface 402a of the second frame 402 facing the part of the body of the user and the other surface 402b opposite to the one surface 402a while the electronic device 101 is worn by the user. The electronic component 415 coupled to the printed circuit board 410 may be disposed to face the other surface 402b in the second frame 402 to reduce heat transferred from the electronic component 415 to the part of the body of the user.

According to an embodiment, at least one inlet 405 may include a first inlet 405a formed along the hinge structure 403. For example, the first inlet 405a may provide a space for the hinge structure 403. The first inlet 405a may at least partially expose the hinge structure 403. For example, the first inlet 405a may be a passage for air being flowed into the second frame 402 from the outside of the frame 300. For example, the first inlet 405a may be a gap for the hinge structure 403 provided to rotatably couple the first frame 401 to the second frame 402. The frame 300 may be configured to flow air for cooling the electronic component 415 in the second frame 402 into the second frame 402 by including the first inlet 405a formed along the hinge structure 403.

According to an embodiment, the at least one inlet 405 may face the part (e.g., an ear or a head) of the body of the user while the electronic device 101 is worn on the user. For example, at least one inlet 405 may include the first inlet 405a between the first frame 401 and the second frame 402 rotatably coupled with the first frame 401 and holding the electronic device 101 on the part (e.g., an ear) of the body of the user. The first inlet 405a may be the space formed so that the second frame 402 is rotatable with respect to the first frame 401. The first inlet 405a may face the part of the body of the user to rotate the second frame 402 with respect to the first frame 401.

According to an embodiment, the frame 300 may include at least one outlet 406. For example, at least one outlet 406 may be the passage for air inside the frame 300 to be discharged to the outside of the frame 300. For example, at least one outlet 406 may be spaced apart from at least one inlet 405. Heat discharged from the electronic component 415 in the frame 300 may be transferred to air flowed into the at least one inlet 405. The air that has received the heat may be discharged to the outside of the frame 300 through the at least one outlet 406. As the air that has received the heat is discharged to the outside of the frame 300, the electronic device 101 may reduce damage to the electronic device 101 by the heat.

According to an embodiment, at least one outlet 406 may be formed in the frame 300 so as not to face the part of the body of the user while the user wears the electronic device 101. For example, while the electronic device 101 is worn on the user, at least one inlet 405 may be formed along one surface 402a (or the inner side of the frame 300) of the second frame 402 facing the part (e.g., an ear or a head) of the body of the user. For example, at least one outlet 406 may be formed on the other surface 402b (or the outer side of the frame 300) opposite to the one surface 402a of the second frame 402. However, the disclosure is not limited to thereto. Since at least one outlet 406 is formed on the frame 300 so as not to face the part of the body of the user, transfer of heat discharged from the inside of the frame 300 through the at least one outlet 406 to the part of the body of the user may be reduced.

According to an embodiment, the shield can 420 may be disposed on the printed circuit board 410. The shield can 420 may at least partially surround the electronic component 415. For example, the shield can 420 may be disposed on one surface of the printed circuit board 410 on which the electronic component 415 is disposed. The shield can 420 may be coupled to the one surface. For example, the shield can 420 may be fastened on the printed circuit board through at least one component (e.g., solder) between the shield can 420 and the printed circuit board 410. For example, the shield can 420 may be electrically connected to the printed circuit board 410. The shield can 420 may separate the electronic component 415 from another electronic component mounted on the printed circuit board 410. By shielding the electromagnetic waves discharged from the electronic component 415, the shield can 420 may reduce the damage of another electronic component around the electronic component 415 by the electromagnetic waves discharged from the electronic component 415. For example, the shield can 420 may be connected to a ground of the printed circuit board 410. By surrounding the electronic component 415, the shield can 420 may discharge electromagnetic waves discharged from the electronic component 415 through the ground.

According to an embodiment, the housing 430 may be coupled with the shield can 420. For example, the housing 430 may at least partially surround the shield can 420. For example, the housing 430 may surround the shield can 420. For example, the housing 430 may be fastened to the shield can 420. For example, the housing 430 may be attached to the shield can 420. For example, the part of the housing 430 may overlap the shield can 420 when viewed from above (e.g., when viewed from the +z direction). For example, the housing 430 may be electrically connected to the shield can 420 by being coupled with the shield can 420. By being fastened with the shield can 420, the housing 430 may support the printed circuit board 410 coupled with the shield can 420 and on which the electronic component 415 is disposed. For example, the housing 430 may provide a seating space for accommodating the shield can 420. For example, the housing 430 may be at least partially disposed between the printed circuit board 410 and the frame 300. For example, the housing 430 may be disposed in the second frame 402 in which the printed circuit board 410 is disposed among the frame 300. For example, the housing 430 may be disposed on the path of a movement path of air in the frame 300 for the air flowed into at least one inlet 405 to be discharged through at least one outlet 406.

According to an embodiment, the housing 430 may include a cover plate 440. The cover plate 440 may include a first portion 441 disposed on the electronic component 415 and a second portion 442 surrounding the first portion 441. It should be understood that in this disclosure, when an element is referred to as being "on" another element, it may be directly on the other element or there are intervening elements therebetween. For example, in this disclosure, "B disposed on A" may represent "B disposed over A". For example, in this disclosure, "B disposed on A" may represent "B facing A and spaced apart from A." For example, "the first portion 441 disposed on the electronic component 415" may refer, for example, to "the first portion 441 in contact with the electronic component 415." For example, "the first portion 441 disposed on the electronic component 415" may refer, for example, to "the first portion 441 facing the electronic component 415 and spaced apart from the electronic component 415."

For example, the cover plate 440 may be the part of the housing 430 for receiving heat discharged from the electronic component 415. For example, the cover plate 440 may be disposed at least partially between the electronic component 415 and the frame 300. For example, the printed circuit board 410 may be disposed in the second frame 402 including one surface 402a facing the part of the body of the user while the user wears the electronic device 101. The electronic component 415 may be mounted on the printed circuit board 410 to face the other surface 402b opposite to the one surface 402a of the second frame 402. The cover plate 440 may be at least partially disposed between the shield can 420 surrounding at least the part of the electronic component 415 and the other surface 402b.

For example, the first portion 441 may be part of the cover plate 440 facing the electronic component 415. For example, the first portion 441 may be the part that overlaps at least part with the electronic component 415 when viewed from above (e.g., referring to FIG. 4C, when viewed in the +z direction). For example, the first portion 441 may receive heat from the electronic component 415. The first portion 441 may be disposed between the electronic component 415 and the frame 300. For example, the first portion 441 may be the part where heat discharged from the electronic component 415 is transferred through conduction heat transfer.

For example, the second portion 442 may be the part extending from the first portion 441 of the cover plate 440. For example, the second portion 442 may be connected to the first portion 441. For example, the second portion 442 may dissipate heat transferred from the electronic component 415 to the first portion 441. For example, air flowed from the outside of the frame 300 through at least one inlet 405 may contact the second portion 442. The second portion 442 may transfer heat received from the first portion 441 to the air through a convection heat transfer. The air that has received the heat from the second portion 442 may be discharged to the outside of the frame 300 through at least one outlet 406 of the frame 300. Since the air that has received the heat is discharged to the outside of the frame 300, the electronic device 101 may reduce damage to the electronic device 101 by heat discharged from the electronic component 415. The electronic device 101 may require a structure for moving the air flowed into the outside of the frame 300 through the at least one inlet 405 to the second portion 442.

According to an embodiment, an actuator 460 may face the second portion 442 of the cover plate 440. The actuator 460 may be configured to spray (e.g., blow, move or cause air to flow) air flowed into (e.g., received into) the at least one inlet 405 of the frame 300 toward the second portion 442. As used herein the term "spray" used in connection with the actions of the actuator may be used interchangeably with the terms "blow", "move", "flow", etc.

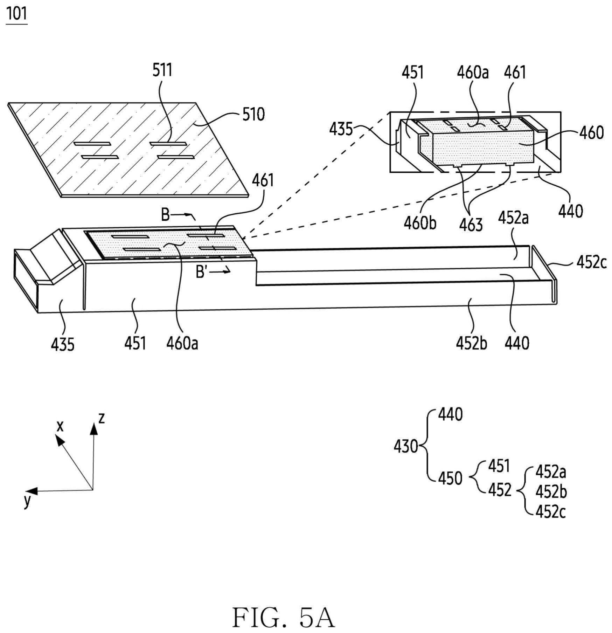

For example, the actuator 460 may be attached to the second portion 442. For example, the actuator 460 may overlap the second portion 442 when viewed from above (e.g., when viewed in the +z direction). For example, the actuator 460 may be spaced apart from the electronic component 415. The actuator 460 may be supported by the cover plate 440. For example, the actuator 460 may be fastened to the housing 430. The actuator 460 may be configured to suck in air inside the frame 300. The actuator 460 may be configured to spray the air sucked in the actuator 460 toward the second portion 442 of the cover plate 440 facing the actuator 460. For example, at least the part of the actuator 460 may vibrate. The actuator 460 may be configured to spray air sucked in the actuator 460 using the vibration. The configuration of the actuator 460 for the vibration will be described later in FIG. 5A. By including an actuator 460 configured to spray air flowed from the outside of the frame 300 through at least one inlet 405 toward the second portion 442 of the cover plate 440, the electronic device 101 may reduce the damage of the electronic device 101 by heat discharged from the electronic component 415.

According to an embodiment, the actuator 460 may be configured to form an air inflow path L from the first inlet 405a between one surface 402a of the second frame 402 facing the part of the body of the user while the electronic device 101 is worn on the user and the printed circuit board 410, to the actuator 460.

For example, the housing 430 and the actuator 460 may be disposed in the second frame 402 in which the printed circuit board 410 is disposed. Air flowed from the outside of the second frame 402 through the first inlet 405a may be moved from the first inlet 405a to the actuator 460 by the actuator 460. A first surface (e.g., a first surface 460a of FIG. 5A) of the actuator 460 through which the air is sucked in may face one surface 402a of the second frame 402 configured to face the part of the body of the user while the electronic device 101 is worn by the user. Since air flowed into the first inlet 405a moves toward the first surface 460a of the actuator 460 in the second frame 402, air inflow path L of the air may be formed along the one surface 402a of the second frame 402. Since the air inflow path L is formed along the one surface 402a of the second frame 402, the electronic device 101 may reduce the transfer of heat discharged from the electronic component 415 to the part of the body of the user through the one surface 402a while the electronic device 101 is worn by the user.

For example, the electronic component 415 and the cover plate 440 may be disposed toward the other surface 402b opposite to one surface 402a of the second frame 402. Heat transferred from the electronic component 415 to the first portion 441 of the cover plate 440 may be dissipated through the second portion 442 surrounding the first portion 441. The actuator 460 may include a second surface (e.g., a second surface 460b of FIG. 5A) opposite to the first surface 460a facing the one surface 402a of the second frame 402. The second surface 460b may face the second portion 442 of the cover plate 440 by facing the other surface 402b opposite to the one surface 402a of the second frame 402. The actuator 460 may move the air to the second portion 442 by spraying the air sucked in through the first surface 460a through the second surface 460b. Heat transferred from the first portion 441 to the second portion 442 may be transferred to the air sprayed to the second portion 442. The cover plate 440 may be cooled by the air sprayed to the second portion 442. Since the cover plate 440 is disposed along the other surface 402b of the second frame 402 in the second frame 402, the electronic device 101 may reduce the transfer of heat discharged from the electronic component 415 to the cover plate 440 to the part of the body of the user of the electronic device 101.

According to an embodiment, the frame 300 may include at least one outlet 406 for discharging air sprayed from the actuator 460 toward the second portion 442 to the outside. The housing 430 may include a duct 435, connected to the second portion, for moving the air toward the at least one outlet 406. For example, the duct 435 may be spaced apart from the printed circuit board 410. For example, the duct 435 may be in contact with actuator 460. For example, the duct 435 may pass air sprayed from the actuator 460 toward the second portion 442. The duct 435 may be disposed toward at least one outlet 406 in the frame 300. For example, the duct 435 may be connected to at least one outlet 406. By including the duct 435 for moving air sprayed from the actuator 460 toward the second portion 442 to at least one outlet 406, the housing 430 may discharge the air that has received heat from the second portion 442 to the outside of the frame 300 through the at least one outlet 406. By discharging the air to the outside of the frame 300, the electronic device 101 may reduce damage to the electronic device 101 by the heat.

According to an embodiment, a direction (e.g., the -z direction) of the actuator 460 toward the second portion 442 may be substantially perpendicular to a direction (e.g., the +y direction) of the duct 435 toward the at least one outlet 406. For example, the direction in which air is sprayed from the actuator 460 toward the second portion 442 (e.g., -z direction) may be perpendicular to the direction in which air is moved toward at least one inlet 405 through the duct 435 after being sprayed into the second portion 442. Since the electronic device 101 is configured so that the direction in which the actuator 460 faces the second portion 442 is perpendicular to the direction in which the duct 435 faces the at least one outlet 406, thickness of the frame 300 (e.g., the second frame 402) in which the housing 430 and the actuator 460 are disposed may be reduced and the wearability for the user of the electronic device 101 may be improved.

According to an embodiment, the housing 430 may include a support structure 450 for supporting components in the electronic device 101 coupled with the housing 430. For example, the support structure 450 may be connected to the cover plate 440. The support structure 450 may surround the shield can 420 and/or the actuator 460. The support structure 450 may be coupled with the shield can 420 and/or the actuator 460. For example, at least the part of the support structure 450 may extend from the cover plate 440 toward the printed circuit board 410. By including the support structure 450, the housing 430 may reduce the shield can 420 and/or the actuator 460 from being separated from the housing 430.

According to an embodiment, the support structure 450 may include a first support structure 451, at least partially surrounding the actuator 460, extending from the cover plate 440. For example, the first support structure 451 may extend from the second portion 442 of the cover plate 440. The first support structure 451 may face at least the part of the actuator 460. For example, the first support structure 451 may provide a seating space for the actuator 460. For example, the first support structure 451 may be connected to the duct 435. By including the first support structure 451 supporting the actuator 460, the support structure 450 may reduce the actuator 460 from being separated from the housing 430.

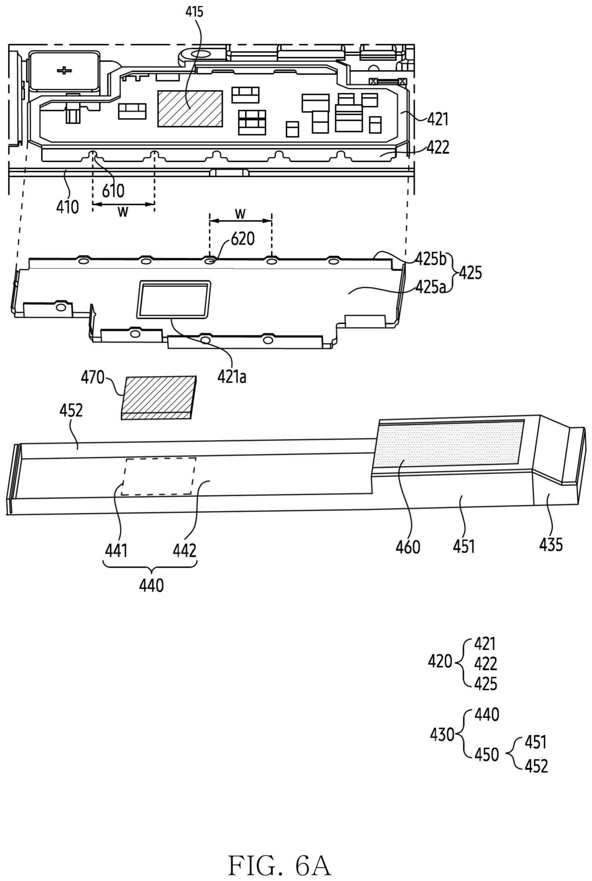

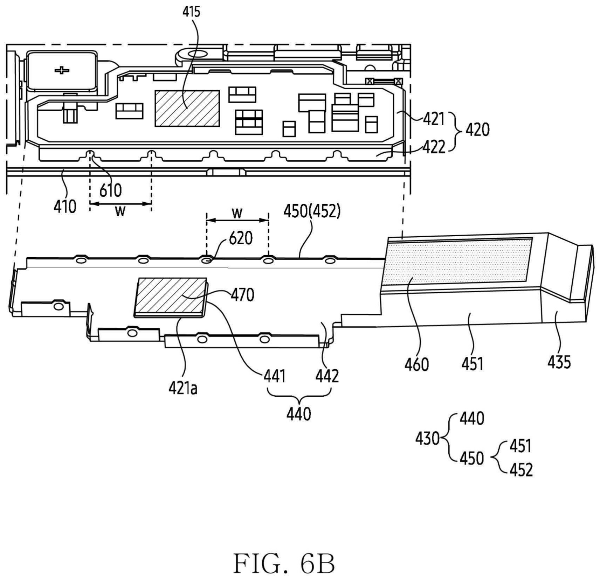

According to an embodiment, the support structure 450 may include a second support structure 452, surrounding shield can 420, extending from the second portion 442 of the cover plate 440. The shield can 420 may include a base 421 facing the cover plate 440 and a sidewall 422 extending from the base 421 toward the printed circuit board 410. For example, the second support structure 452 may cover at least the part of the shield can 420. The first support structure 452 may provide a seating space for the shield can 420. For example, at least the part of the second support structure 452 may be connected to the first support structure 451. For example, the second support structure 452 may be coupled with the shield can 420. By being coupled with the shield can 420, the second support structure 452 may shield electromagnetic waves discharged from the electronic component 415 surrounded by the shield can 420 with the shield can 420. For example, the second support structure 452 may include a first support part 452a, a second support part 452b facing the first support part 452a, and a third support part 452c in contact with the first support part 452a and the second support part 452b. By surrounding the shield can 420, the support parts 452a, 452b, and 452c may shield electromagnetic waves discharged from the electronic component 415 with the shield can 420. The coupling structure for shielding the electromagnetic wave by the second support structure 452 with the shield can 420 will be described later below FIG. 6.

For example, the base 421 of the shield can 420 may be attached to the cover plate 440. The base 421 may face the second portion 442 of the cover plate 440. For example, the base 421 may overlap the second portion 442 of the cover plate 440 when viewed from above (e.g., when viewed in the +z direction). For example, the base 421 may be spaced apart from the printed circuit board 410. For example, the sidewall 422 of the shield can 420 may be disposed along a periphery of the base 421. The sidewall 422 may connect the base 421 and the printed circuit board 410. For example, the sidewall 422 may be the part of the shield can 420 that is coupled to the printed circuit board 410. The sidewall 422 may be the part of the shield can 420 that surrounds the electronic component 415. For example, the sidewall 422 may be coupled with the second support structure 452. The sidewall 422 may be covered by the second support structure 452. For example, the sidewall 422 may be the part of the shield can 420 that is coupled with the support parts 452a, 452b, and 452c of the second support structure 452.

According to an embodiment, the shield can may include a hole 421a, penetrating the shield can 420, facing the electronic component 415. The electronic device 101 may include a heat conduction member (e.g., including thermally conductive material) 470 interposed between the electronic component 415 and the first portion 441 through the hole 421a. For example, the hole 421a may face the first portion 441 of the cover plate 440. For example, the hole 421a may at least partially overlap the first portion 441 of the cover plate 440 when viewed from above (e.g., when viewed in the +z direction). For example, the hole 421a may provide a heat transfer path for the heat discharged from the electronic component 415 to be transferred to the cover plate 440. For example, the hole 421a may be formed in the base 421 of the shield can 420. The hole 421a may penetrate the base 421 to transfer heat from the electronic component 415 to the first portion 441 of the cover plate 440.

For example, the heat conduction member 470 may pass through the hole 421a. The heat conduction member 470 may be attached to the electronic component 415 by passing through the hole 421a. For example, the heat conduction member 470 may be in contact with the electronic component 415 and the first portion 441. For example, the heat conduction member 470 may be disposed between the first portion 441 of the cover plate 440 and the electronic component 415 through a hole 421a. By being disposed between the first portion 441 and the electronic component 415, the heat conduction member 470 may provide the heat transfer path from the electronic component 415 to the first portion 441. At least the part of heat discharged from the electronic component 415 may be transferred to the first portion 441 through conduction heat transfer by the heat conduction member 470. By including the heat conduction member 470, the electronic device 101 may dissipate heat discharged from the electronic component 415 through the cover plate 440.

According to the above-described embodiment, by including a housing 430 that dissipates heat discharged from the electronic component 415, the electronic device 101 may reduce damage to the electronic device 101 by the heat. By including the frame 300 including at least one inlet 405 and at least one outlet 416, the electronic device 101 may cool the housing 430 that receives the heat from the electronic component 415 through air flowed into the frame 300 through the at least one inlet 405. The electronic device 101 may cool the housing 430 by including an actuator 460 configured to spray the air toward the housing 430. By including a duct 435 that discharges the air sprayed from the actuator 460 and transferred heat from the housing 430 to the outside of the frame 300 through the at least one outlet 406, the housing 430 may reduce the damage to the electronic device 101 by the heat.

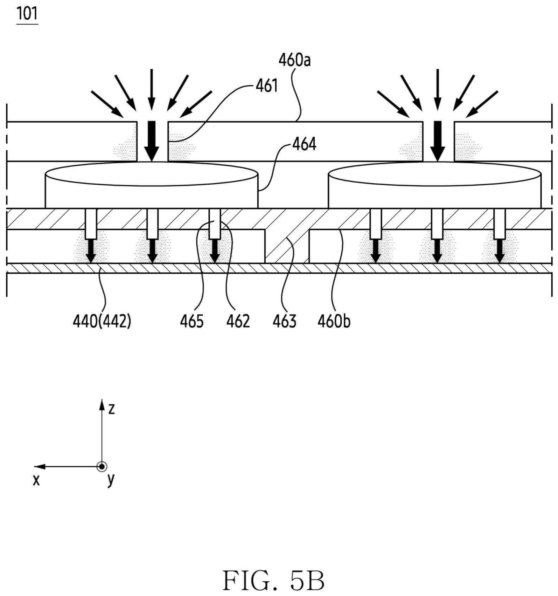

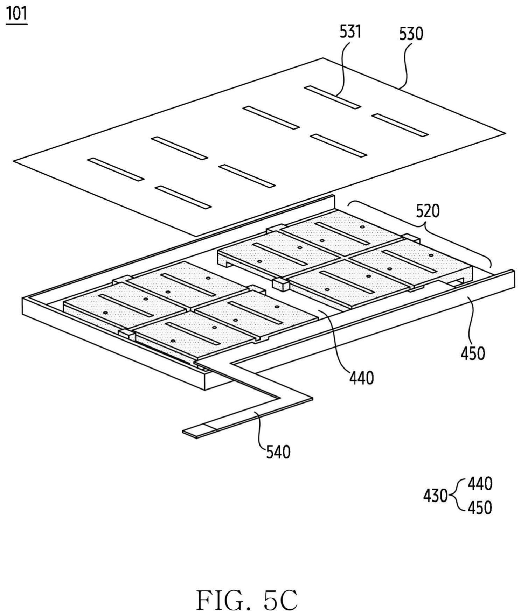

FIG. 5A illustrates a part of an example of an electronic device according to various embodiments. FIG. 5B is a partial cross-sectional view of an example of an electronic device taken along line B-B' of FIG. 5A. FIG. 5C illustrates a part of an example of an electronic device according to various embodiments.

Referring to FIGS. 5A and 5B, an electronic device 101 may include a frame (e.g., a frame 300 of FIG. 4a) including at least one inlet (e.g., at least one inlet 405 of FIG. 4A), a printed circuit board 410 in the frame 300, an electronic component 415 on the printed circuit board 410, and a shield can 420 on the printed circuit board 410 at least partially surrounding the electronic component 415. The electronic device 101 may include a housing 430, coupled with the shield can 420, including a cover plate 440 including a first portion (e.g., a first portion 441 of FIG. 4C) disposed on the electronic component 415 and a second portion (e.g., a second portion 442 of FIG. 4C) surrounding the first portion 441. The electronic device 101 may include an actuator 460 facing the second portion 442. The actuator 460 may be configured to spray air flowed into the at least one inlet 405 toward the second portion 442. According to an embodiment, the housing 430 may include a first support structure 451 for supporting the actuator 460, a second support structure 452 for supporting the shield can 420, and may a support structure 450 extending from the cover plate 440, and a duct 435.

Hereinafter, a redundant description of a configuration having the same reference numerals described above in FIGS. 4A, 4B, 4C and 4D may not be repeated.

According to an embodiment, the actuator 460 may include a first surface 460a toward the second portion 442, including a first openings 461, a second surface 460b, opposite to the first surface 460a, including a second openings 462, and a protruding structure 463, extending from the second surface 460b to the second portion 442 of the cover plate 440, attached to the second portion 442.

For example, the first surface 460a may face a portion (e.g., one surface 402a of FIG. 4A), among the frame 300, facing a part of a body of a user, while the electronic device 101 is worn by the user. For example, the first surface 460a may be the part that sucks in air in the frame 300 through the first openings 461. For example, the second surface 460b may face the second portion 442 of the cover plate 440. The second surface 460b may be the part that sprays air sucked into the actuator 460 through the first openings 461 toward the second portion 442 through the second openings 462.

For example, the protruding structure 463 may protrude from the second surface 460b toward the cover plate 440. The protruding structure 463 may support the actuator 460 by being fastened to the cover plate 440. For example, the protruding structure 463 may be attached to the second portion 442 of the cover plate 440 through an adhesive member (e.g., an adhesive) between the actuator 460 and the cover plate 440. For example, by being protruded from the second surface 460b toward the second portion 442, the protruding structure 463 may space the second portion 442 from the portion of the second surface 460b where the second openings 462 are formed. The protruding structure 463 may provide a gap between the actuator 460 and the second portion 442 for air sprayed from the second openings 462 toward the second portion 442 by spacing the second openings 462 from the second portion 442.

According to an embodiment, the actuator 460 may include at least one vibrating element 464 disposed between the first surface 460a and the second surface 460b, and at least one nozzle disposed in the second openings 462. The actuator 460 may be configured to spray air flowed into the first openings 461 from at least one inlet 405 of the frame 300 toward the second portion 442 of the cover plate 440 through the at least one nozzle 465, by vibrating the vibration element 464.

For example, at least one vibration element 464 may be disposed inside the actuator 460. The at least one vibration element 464 may be configured to vibrate by receiving power. For example, at least one vibration element 464 may be configured to vibrate in the actuator 460 in a direction (e.g., +z direction) toward the first surface 460a of the actuator 460 and in a direction (e.g., -z direction) toward the second surface 460b opposite to the first surface 460a. At least one vibration element 464 may be referred to as Micro Electro Mechanical Systems (MEMS), but is not limited thereto. For example, at least one nozzle 465 may be coupled in the second openings 462. For example, at least one nozzle 465 may provide a movement path for the air flowed into the actuator 460 to move to the cover plate 440.

For example, by being configured to vibrate in the actuator 460, the at least one vibration element 464 may increase a flow rate of air suck into an inside of the actuator 460 through the first openings 461. At least one nozzle 465 disposed within the second openings 462 may increase the flow rate of the air by spraying the air sucked into the actuator 460 toward the second portion 442. The actuator 460 may increase cooling efficiency of the second portion 442 of the cover plate 440 by including the at least one vibration element 464 and the at least one nozzle 465 configured to spray air flowed into the inside of the actuator 460 at the relatively high flow rate.

According to an embodiment, the first support structure 451 may at least partially surrounding the actuator 460. The electronic device 101 may include a fastening member 510 attached on the actuator 460 and the first support structure 451 to fasten the actuator 460 to the housing 430. For example, the fastening member 510 may cover at least the part of the actuator 460 and the housing 430. For example, the fastening member 510 may be attached on the first surface 460a of the actuator 460. By being attached to the first surface 460a and the first support structure 451, as the actuator 460 operates, the fastening member 510 may reduce separation of the actuator 460 from the first support structure 451 and allowing air sprayed from the second surface 460b opposite to the first surface 460a to move through the duct 435. For example, the fastening member 510 may include first through holes 511 for the first openings 461 formed in the first surface 460a of the actuator 460. By overlapping the first openings 461, each of the first through holes 511 may provide a passage for the internal air of the frame 300 through the first openings 461 to flow.

Referring to FIG. 5C, a plurality of actuators 520 may be disposed in the housing 430. Each of the plurality of actuators 520 may be configured to be substantially the same as or similar to the actuator 460 of FIGS. 5A and 5B. For example, each of the plurality of actuators 520 may include the protruding structure 463 protruded toward the cover plate 440 to spray air into the cover plate 440. By including at least one vibration element 464 and at least one nozzle 465 respectively, the plurality of actuators 520 may be configured to spray air toward the cover plate 440.

According to an embodiment, the electronic device 101 may include a cover member 530 coupled with the support structure 450 that at least partially surrounds the plurality of actuators 520 and covering the plurality of actuators 520. The cover member 530 may reduce the separation of the plurality of actuators 520 from the housing 430 by covering the plurality of actuators 520. By including second through holes 531 penetrating the cover member 530, the cover member 530 may provide the passage for the internal air of the frame 300 to flow into the plurality of actuators 520.

According to an embodiment, the electronic device 101 may include a flexible printed circuit board 540 connected to the plurality of actuators 520. The flexible printed circuit board 540 may be connected to the printed circuit board 410 in the electronic device 101. The flexible printed circuit board 540 may drive the plurality of actuators 520 by supplying power to the plurality of actuators 520.

According to the above-described example, the electronic device 101 may reduce the damage of the electronic device 101 by heat, by including an actuator (an actuator 460 of FIG. 4B, a plurality of actuators 520 of FIG. 5C) for cooling the housing 430 that has received heat from the electronic component 415.

FIG. 6A and FIG. 6B illustrate a part of an example of an electronic device according to various embodiments.

Referring to FIG. 6A and FIG. 6B, an electronic device 101 may include a frame (e.g., a frame 300 of FIG. 4A) including at least one inlet (e.g., at least one inlet 405 of FIG. 4A), a printed circuit board 410 in the frame 300, an electronic component 415 on the printed circuit board 410, and a shield can 420 on the printed circuit board 410 at least partially surrounding the electronic component 415. The electronic device 101 may include a housing 430, coupled with the shield can 420, including a cover plate 440 including a first portion 441 disposed on the electronic component 415 and a second portion 442 surrounding the first portion 441. The electronic device 101 may include an actuator 460 facing the second portion 442. The actuator 460 may be configured to spray air flowed into the at least one inlet 405 (e.g., at least one inlet 405 of FIG. 4A) toward the second portion 442. According to an embodiment, the housing 430 may include a first support structure 451 for supporting the actuator 460, a second support structure 452 for supporting the shield can 420, and may a support structure 450 extending from the cover plate 440, and a duct 435. According to an embodiment, the frame (e.g., the frame 300 of FIGS. 2 and 3) may include at least one outlet (e.g., at least one outlet 406 of FIG. 4A). The at least one outlet 406 may be configured to discharge heat discharged from the electronic component 415 to the outside of the frame 300.

Referring to FIG. 6A, the shield can 420 may include a cover 425 for shielding the shield can 420. The cover 425 may cover the electronic component 415. The cover 425 may be coupled with a sidewall 422. According to an embodiment, the cover 425 may be referred to as the housing 430 and/or the part of the housing 430. However, the disclosure is not limited to thereto.

According to an embodiment, the cover 425 may include a cover portion 425a disposed on the electronic component 415 and a coupling part 425b disposed along a periphery of the cover part 425a and coupled to the sidewall 422. The cover part 425a may be attached on the cover plate 440. The coupling part 425b may be coupled to the second support structure 452. The cover part 425 may transfer at least the part of heat received from the electronic component 415 to the cover plate 440.

According to an embodiment, the coupling part 425b may surround the sidewall 422. The sidewall 422 may include the plurality of fastening holes 610. The coupling part 425b may include the plurality of protrusions 620 respectively fastened to the plurality of fastening holes 610 to shield the shield can 420.

For example, the plurality of fastening holes 610 may face the printed circuit board 410. The plurality of fastening holes 610 may be disposed along the sidewall 422 of the shield can 420. Each of the plurality of fastening holes 610 may penetrate the sidewall 422. The plurality of fastening holes 610 may be spaced apart from a hole 421a formed in the base 421 of the shield can 420. For example, the plurality of protrusions 620 may protrude from an inner surface of the second support structure 452. Each of the plurality of protrusions 620 may be coupled with the plurality of fastening holes 610 of the shield can 420. For example, each of the plurality of fastening holes 610 may have a shape corresponding to the shape of the plurality of protrusions 620.

For example, the plurality of protrusions 620 may be inserted into the plurality of fastening holes 610. The coupling part 425b may be coupled with the sidewall 422 of the shield can 420 through the plurality of protrusions 620 fastened to the plurality of fastening holes 610. Since the plurality of protrusions 620 are respectively inserted into the plurality of fastening holes 610, the sidewall 422 may shield the electronic component 415 with the coupling part 425b. The cover plate 440 of the housing 430 may shield the electronic component 415 with the cover part 425a by covering the opening 421a formed in the base 421 of the shield can 420. By being coupled with the shield can 420 and shielding the electronic component 415 with the shield can 420, the housing 430 may increase a shielding performance of electromagnetic waves discharged from the electronic component 415.

According to an embodiment, the plurality of protrusions 620 may be spaced apart from each other at a designated distance w along the second support structure 452 (or the coupling part 425a), respectively. The designated distance w may be located within a range of 2mm to 8mm. For example, the plurality of protrusions 620 may be formed at the coupling part 425a so as to be spaced apart from each other, respectively, at the designated distance w. The plurality of fastening holes 610 fastened to the plurality of protrusions 620 may be formed along the sidewall 422 of the shield can 420, respectively to be spaced apart from each other at the designated distance w. Since the designated distance w is located within a range of 2mm to 8mm, the electronic device 101 may reduce the separation of the housing 430 from the shield can 420 and increase the shielding performance for the electronic component 415.

According to an embodiment, the shield can 420 and the housing 430 each may include metal. For example, the housing 430 and the shield can 420 may be electrically connected to each other by including a metal, respectively. Electromagnetic waves discharged from the electronic component 415 may be discharged to a ground of the printed circuit board 410 through the shield can 420 and/or the housing 430. Since the shield can 420 and the housing 430 each include metal, the electronic device 101 may reduce damage to the shield can 420 and the housing 430 by an external impact and increase the shielding performance for the electronic component 415.

According to an embodiment, the housing 430 may have a shape corresponding to a shape of the shield can 420. Since the housing 430 has the shape corresponding to the shape of the shield can 420, the housing 430 may be fastened to the shield can 420. The housing 430 may increase the shielding performance for the electronic component 415 by surrounding the shield can 420.

Referring to FIG. 6B, the cover 425 of the shield can 420 may be omitted. The housing 430 may function or be referred to as the cover 425 of the shield can 420.

According to an embodiment, a second support structure 452 of the housing 430 may surround the shield can 420. The sidewall 422 of the shield can 420 may include the plurality of fastening holes 610. The second support structure 452 may include the plurality of protrusions 620 respectively fastened to the plurality of fastening holes 610 to shield the shield can 420. For example, the plurality of protrusions 620 may protrude from the inner surface of the second support structure 452. The plurality of protrusions 620 respectively may be coupled with the plurality of fastening holes 610 of the shield can 420. For example, the plurality of protrusions 620 may be inserted into the plurality of fastening holes 610. The second support structure 452 may be coupled with the sidewall 422 of the shield can 420 through the plurality of protrusions 620 fastened to the plurality of fastening holes 610. Since the plurality of protrusions 620 are respectively inserted into the plurality of fastening holes 610, the sidewall 422 may shield the electronic component 415 with the second support structure 452. The cover plate 440 of the housing 430 may shield the electronic component 415 with the base 421, by covering the opening 421a formed in the base 421 of the shield can 420. By being coupled with the shield can 420 and shielding the electronic component 415 with the shield can 420, the housing 430 may increase the shielding performance of electromagnetic waves discharged from the electronic component 415.

According to an embodiment, the plurality of protrusions 620 may be spaced apart from each other at the designated distance w along the second support structure 452, respectively. The designated distance w may be located within the range of 2mm to 8mm. For example, the plurality of protrusions 620 may be formed at the second support structure 452 so as to be spaced apart from each other, respectively, at the designated distance w. The plurality of fastening holes 610 fastened to the plurality of protrusions 620 may be formed along the sidewall 422 of the shield can 420, respectively to be spaced apart from each other at the designated distance w. Since the designated distance w is located within the range of 2mm to 8mm, the electronic device 101 may reduce the separation of the housing 430 from the shield can 420 and increase the shielding performance for the electronic component 415.

According to the above-described embodiment, the electronic device 101 may improve the shielding performance for the electronic component 415 surrounded by the shield can 420, by including the housing 430 fastened to the shield can 420. By being configured to dissipate heat transferred from the electronic component 415, the housing 430 may reduce damage to the electronic device 101 by the heat.

FIG. 7 illustrates an example of an electronic device according to various embodiments.

Referring to FIG. 7, an electronic device 101 may include a frame 300 including at least one inlet 405, a printed circuit board (e.g., a printed circuit board 410 of FIG. 4B) in the frame 300, an electronic component (e.g., an electronic component 415 of FIG. 4B) on the printed circuit board 410 and a shield can (e.g., a shield can 420 of FIG. 4B) on the printed circuit board 410 at least partially surrounding the electronic component 415. The electronic device 101 may include a housing (e.g., a housing 430 of FIG. 4B), coupled with the shield can 420, including a cover plate (e.g., a cover plate 440 of FIG. 4B) including a first portion (e.g., a first portion 441 of FIG. 4C) disposed on the electronic component 415 and a second portion (e.g., a second portion 442 of FIG. 4C) surrounding the first portion 441. The electronic device 101 may include an actuator (e.g., an actuator 460 of FIG. 4B) facing the second portion 442. The actuator 460 may be configured to spray air flowed into the at least one inlet 405 toward the second portion 442.

According to an embodiment, the electronic device 101 may include at least one display (e.g., at least one display 210 of FIG. 2). The frame 300 may include a first frame 401 supporting the at least one display 210, a second frame 402 supported by a part (e.g., an ear) of a body of a user while the electronic device 101 is worn on the user, and a hinge structure (e.g., a hinge structure 403 of FIG. 4A) rotatably connecting the second frame 402 to the first frame 401. The printed circuit board 410 may be disposed in the second frame 402.

According to an embodiment, at least one inlet 405 may include second inlets 710 and third inlets 720 formed in the first frame 401. For example, the second inlets 710 may include a second inlet 711 formed in a first rim 301 supporting a first display 210-1, a third inlet 712 formed in a second rim 302 supporting a second display 210-2, and a fourth inlet 713 formed in a bridge 303 connecting the first rim 301 and the second rim 302. For example, the third inlets 720 may include microphone holes 721 and 722. However, the disclosure is not limited thereto, and the frame 300 may include a plurality of inlets. For example, the frame 300 may include a third frame 404 rotatably coupled with the first frame 401. The first frame 401, the second frame 402, and the third frame 404 may include the plurality of inlets for flowing air from the outside of the frame 300 into the inside of the frame 300.

According to an embodiment, the frame 300 may include at least one outlet (e.g., at least one outlet 406 of FIG. 4A). The at least one outlet 406 may include the plurality of outlets formed in each of the frames 401, 402, and 404. For example, although not illustrated, at least one outlet 406 may be referred to as a speaker hole formed in the second frame 402 and the third frame 404, respectively. However, the disclosure is not limited to thereto. The frame 300 may be configured to discharge heat discharged from the electronic component 415 to the outside of the frame 300 through the air by including the plurality of outlets for air flowed into the frame 300.

According to an embodiment, by including at least one inlet 405 and at least one outlet 406, the frame 300 of the electronic device 101 may reduce the damage of the electronic device 101 by heat discharged from the electronic component 415 inside the frame 300.

According to an example embodiment, a wearable device (e.g., an electronic device 101 in FIG. 1) may include: a frame (a frame 300 of FIG. 2) including at least one inlet (e.g., at least one inlet 405 of FIG. 4A), a printed circuit board (e.g., a printed circuit board 410 of FIG. 4B) disposed in the frame, an electronic component (e.g., an electronic component 415 of FIG. 4B) disposed on the printed circuit board and a shield can (e.g., a shield can 420 of FIG. 4B) disposed on the printed circuit board at least partially surrounding the electronic component. The wearable device may include: a housing (e.g., a housing 430 of FIG. 4B), coupled with the shield can, including a cover plate (e.g., a cover plate 440 of FIG. 4B) including a first portion (e.g., a first portion 441 of FIG. 4B) disposed on the electronic component and a second portion (e.g., a second portion 442 of FIG. 4B) surrounding the first portion. The wearable device may include an actuator (e.g., an actuator 460 of FIG. 4B) facing the second portion. The actuator may be configured to spray air flowed into the at least one inlet toward the second portion. According to an example embodiment, the wearable device may dissipate heat discharged from the electronic component by including the housing. The wearable device may cool the housing that has received heat from the electronic component by including the actuator. The various embodiments, including above mentioned embodiment, described below may have various effects including the above-mentioned effect.

According to an example embodiment, the shield can may include a hole (e.g., the hole 421a of FIG. 4C), penetrating the shield can, facing the electronic component. The wearable device may further include a heat conduction member (e.g., a heat conduction member 470 of FIG. 4B) interposed between the electronic component and the first portion through the hole. According to the above-mentioned embodiment, the wearable device may transfer heat from the electronic component to the housing by including the heat conduction member.

According to an example embodiment, the actuator may include a first surface (e.g., a first surface 460a of FIG. 5A) toward the second portion, including a first openings (e.g., first openings 461 of FIG. 5B), a second surface (e.g., a second surface 460b of FIG. 5A), opposite to the first surface, including a second openings (e.g., second openings 462 of FIG. 5B), and a protruding structure (e.g., a protruding structure 463 of FIG. 5A), extending from the second surface to the second portion, attached to the second portion. According to the above-mentioned embodiment, the wearable device may cool the housing that has received heat from the electronic component by including the actuator.

According to an example embodiment, the actuator may further include at least one vibrating element (e.g., at least one vibrating element 464 of FIG. 5B) disposed between the first surface and the second surface, and at least one nozzle (e.g., at least one nozzle 465 of FIG. 5B) disposed in the second openings. The actuator may be configured to spray air flowed into the first openings from the at least one inlet toward the second portion through the nozzle, by vibrating the vibration element. According to the above-mentioned embodiment, the wearable device may cool the housing that has received heat from the electronic component by including the actuator.

According to an example embodiment, the housing may further include a first support structure (e.g., a first support structure 451 of FIG. 4C), at least partially surrounding the actuator, extending from the cover plate. The wearable device may further include a fastening member (e.g., a fastening member 510 of FIG. 5A) attached on the actuator and the first support structure to fasten the actuator to the housing. According to the above-mentioned embodiment, by including the fastening member, the wearable device may reduce the actuator from being separated from the housing.

According to an example embodiment, the housing may further include a second support structure (e.g., a second support structure 452 of FIG. 4C), surrounding the shield can, extending from the second portion. The shield can may include a base (e.g., a base 421 of FIG. 4C) facing the cover plate, and a sidewall (e.g., a sidewall 422 of FIG. 4C) extending from the base toward the printed circuit board. According to the above-mentioned embodiment, the wearable device may shield electromagnetic waves discharged from the electronic component by including the shield can.

According to an example embodiment, the sidewall may include a plurality of fastening holes (e.g., a plurality of fastening holes 610 of FIG. 6). The second support structure may include the plurality of protrusions (e.g., a plurality of protrusions 620 of FIG. 6) respectively fastened to the plurality of fastening holes to shield the shield can. According to the above-mentioned embodiment, the housing may shield electromagnetic waves discharged from the electronic component with the shield can, by being coupled with the shield can.

According to an example embodiment, the plurality of protrusions may be spaced apart from each other at a designated distance (e.g., w of FIG. 6) along the second support structure, respectively. The designated distance may be located within a range of 2mm to 8mm. According to the above-mentioned embodiment, the housing may shield electromagnetic waves discharged from the electronic component with the shield can, by being coupled with the shield can.

According to an example embodiment, the shield can and the housing each may include metal. According to the above-mentioned embodiment, the housing and the shield can may shield electromagnetic waves discharged from the electronic component by including metal, respectively.

According to an example embodiment, the frame may further include at least one outlet (e.g., at least one outlet 406 of FIG. 4A) for discharging the air sprayed from the actuator toward the second portion to an outside of the frame. The housing may further include a duct (e.g., a duct 435 of FIG. 4B), connected to the second portion, for moving the air toward the at least one outlet. According to the above-mentioned embodiment, the housing may provide a path for the air in the frame to be discharged to the outside of the frame, by including the duct.

According to an example embodiment, a direction of the actuator toward the second portion may be perpendicular to a direction of the duct toward the at least one outlet. According to the above-mentioned embodiment, the housing may provide the path for the air in the frame to be discharged to the outside of the frame, by including the duct.

According to an example embodiment, the electronic device may further include at least one display (e.g., at least one display 210 of FIG. 2). The frame may further include a first frame (e.g., the first frame 401 of FIG. 4A) supporting the at least one display, a second frame (e.g., the second frame 402 of FIG. 4A) in which the printed circuit board is disposed, supported by a part of a body of a user while the wearable device is worn on the user, and a hinge structure (e.g., a hinge structure 403 of FIG. 4A) rotatably connecting the second frame to the first frame. According to the above-mentioned embodiment, the frame may provide the user with various user experience by including the first frame, the second frame, and the hinge structure.

According to an example embodiment, the at least one inlet may include a first inlet (e.g., a first inlet 405a of FIG. 4A) formed along the hinge structure. The actuator may be configured to form an air inflow path (e.g., an air inflow path L of FIG. 4B) from the first inlet between one surface (e.g., one surface 402a of FIG. 4A) of the second frame facing the part of the body of the user while the wearable device is worn on the user and the printed circuit board, to the actuator. According to the above-mentioned embodiment, the wearable device may reduce heat transferred from the electronic component to the frame by being configured to form the air inflow path.

According to an example embodiment, the at least one inlet may include a second inlets (e.g., the second inlets 710 in FIG. 7) formed on the first frame. According to the above-mentioned embodiment, the frame may reduce damage to the wearable device by the electronic component by including the second inlets.

According to an example embodiment, the housing may have a shape corresponding to a shape of the shield can. According to the above-mentioned embodiment, the housing may shield electromagnetic waves of the electronic component with the shield can, by having the shape corresponding to the shield can.

According to an example embodiment, a wearable device may include a frame including at least one inlet, the printed circuit board in the frame, and an electronic component on the printed circuit. The wearable device may include the housing including the cover plate including the first portion disposed on the electronic component and the second portion surrounding the first portion. The wearable device may include the actuator, toward the second portion, including a first surface including the first openings, the second surface opposite to the first surface and including the second openings, and a protruding structure extending from the second surface to the second portion and attached to the second portion. The actuator may be configured to spray air flowed into the at least one inlet from the first surface toward the second portion. According to the above-mentioned embodiment, the wearable device may dissipate heat discharged from the electronic component, by including the housing. The wearable device may cool the housing that has received heat from the electronic component, by including the actuator. The above-mentioned embodiment may have various effect including the above-mentioned effect.

According to an example embodiment, the electronic device may further include a shield can on the printed circuit board coupled to the housing, at least partially surrounding the electronic component, including the hole facing the electronic component. The wearable device may further include a heat conduction member interposed between the electronic component and the first portion through the hole. According to the above-mentioned embodiment, the wearable device may transfer heat from the electronic component to the housing, by including the heat conduction member.

According to an example embodiment, the actuator may further include at least one vibrating element between the first surface and the second surface, and at least one nozzle disposed in the second openings. The actuator may be configured to spray the air flowed into the first openings from the at least one inlet toward the second portion through the nozzle, by vibrating the vibration element. According to the above-mentioned embodiment, the wearable device may cool the housing that has received heat from the electronic component, by including the actuator.

According to an example embodiment, the frame may further include at least one outlet for discharging the air sprayed from the actuator toward the second portion to an outside of the frame. The housing may further include a duct, connected to the second portion, for moving the air toward the at least one outlet. According to the above-mentioned embodiment, the housing may provide the path for the air in the frame to be discharged to the outside of the frame, by including the duct.

According to an example embodiment, the electronic device may further include at least one display. The frame may further include the first frame supporting the at least one display, the second frame in which the printed circuit board is disposed and supported by the part of the body of the user while the wearable device is worn on the user, and the hinge structure rotatably connecting the second frame to the first frame. The at least one inlet may include the first inlet formed along the hinge structure. The actuator may be configured to form an air inflow path from the first inlet between one surface of the second frame facing the part of the body of the user while the wearable device is worn on the user and the printed circuit board, to the actuator. According to the above-mentioned embodiment, the wearable device may reduce heat transferred from the electronic component to the frame by being configured to form the air inflow path.

The effect to be achieved in this disclosure is not limited to the effects mentioned above, and other effects not mentioned may be clearly understood by a person of ordinary knowledge in the technical field to which this disclosure belongs.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), the element may be coupled with the other element directly (e.g., wiredly), wirelessly, or via a third element.

As used in connection with various embodiments of the disclosure, the term "module" may include a unit implemented in hardware, software, or firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. A wearable device (101) comprising:
a frame (300) including at least one inlet (405);
a printed circuit board (PCB) (410) disposed in the frame (300);
an electronic component (415) disposed on the PCB (410);
a shield can (420), coupled to the PCB (410), at least partially surrounding the electronic component (415);
a housing (430), coupled with the shield can (420), including a cover plate (440) including a first portion (441) disposed on the electronic component (415) and a second portion (442) surrounding the first portion (441); and
an actuator (460) disposed toward the second portion (442),
wherein, the actuator (460) is configured to move air received through the at least one inlet (405) toward the second portion (442).

2. The wearable device (101) of claim 1,
wherein the electronic component (415) comprising electronic circuitry,
wherein the shield can (420) includes a hole (421a) penetrating the shield can (420), facing the electronic component (415), and
wherein, the wearable device (101) further comprises a heat conduction member (470) comprising a thermally conductive material interposed between the electronic component (415) and the first portion (441) through the hole (421a).

3. The wearable device (101) of claim 1,
wherein, the actuator (460) includes:
a first surface (460a), facing the second portion (442), including a first openings (461);
a second surface (460b), opposite to the first surface (460a), including a second openings (462); and
a protrusion (463) extending from the second surface (460b) to the second portion (442), attached to the second portion (442).

4. The wearable device (101) of claim 3,
wherein, the actuator (460) further includes:
at least one vibrating element (464) disposed between the first surface (460a) and the second surface (460b); and
at least one nozzle disposed in the second openings (462),
wherein the actuator (460) is configured to move the air received through the first openings (461) from the at least one inlet (405), toward the second portion (442) through the at least one nozzle, by vibrating the vibrating element (464).

5. The wearable device (101) of claim 1,
wherein the housing (430) further includes a first support (451), at least partially surrounding the actuator (460), extending from the cover plate (440),
wherein, the wearable device (101) further comprises a securing cover (510) attached on the actuator (460) and the first support (451) to fasten the actuator (460) to the housing (430).

6. The wearable device (101) of claim 1,
wherein the housing (430) further includes a second support (452), surrounding the shield can (420), extending from the second portion (442),
wherein the shield can (420) includes:
a base (421) facing the cover plate (440); and
a sidewall (422) extending from the base (421) toward the PCB (410).

7. The wearable device (101) of claim 6,
wherein the sidewall (422) includes a plurality of fastening holes (610),
wherein the second support (452) includes a plurality of protrusions (620) respectively fastened to the plurality of fastening holes (610) and configured to shield the shield can (420).

8. The wearable device (101) of claim 7,
wherein, the plurality of protrusions (620) are spaced apart from each other at a designated distance (w) along the second support (452), respectively and
wherein, the designated distance (w) is within a range of 2mm to 8mm.

9. The wearable device (101) of claim 1,
wherein, the shield can (420) and the housing (430) each comprise a metal.

10. The wearable device (101) of claim 1,
wherein the frame (300) further includes at least one outlet configured to discharge the air moved from the actuator (460) toward the second portion (442) to an outside of the frame (300), and,
wherein the housing (430) further includes a duct (435), connected to the second portion (442), configured to move the air toward the at least one outlet (406).

11. The wearable device (101) of claim 10,
wherein a direction of the actuator (460) toward the second portion (442) is perpendicular to a direction of the duct (435) toward the at least one outlet (406).

12. The wearable device (101) of claim 1 further comprising:
at least one display (210),
wherein the frame (300) further includes:
a first frame (401) configured to support the at least one display (210);
a second frame (402) in which the PCB (410) is disposed, and configured to be supported by a portion of a body of a user based on the wearable device (101) being worn on the user; and
a hinge structure (403) comprising a hinge rotatably connecting the second frame (402) to the first frame (401).

13. The wearable device (101) of claim 12,
wherein the at least one inlet (405) includes a first inlet (405a) formed along the hinge structure (403),
wherein the actuator (460) is configured to form an air inflow path (L) from the first inlet (405a) between one surface (402a) of the second frame (402) facing the portion of a body of the user based on the wearable device (101) being worn on the user and the PCB (410), to the actuator (460).

14. The wearable device (101) of claim 12,
wherein the at least one inlet (405) includes a second inlet (710) formed on the first frame (401).

15. The wearable device (101) of claim 1,
wherein the housing (430) has a shape corresponding to a shape of the shield can (420).
